Europäisches Patentamt

European Patent Office

Office européen des brevets

(19)

(11) Veröffentlichungsnummer: **0 235 550
B1**

(12) **EUROPÄISCHE PATENTSCHRIFT**

(45) Veröffentlichungstag der Patentschrift:
31.10.90

(51) Int. Cl.⁵: **H01L 29/167**

(21) Anmeldenummer: **87100991.6**

(22) Anmeldetag: **24.01.87**

(54) Halbleiterbauelement und Verfahren zu dessen Herstellung.

(30) Priorität: **05.02.86 CH 447/86**

(43) Veröffentlichungstag der Anmeldung:
**09.09.87 Patentblatt 87/37**

(45) Bekanntmachung des Hinweises auf die Patenterteilung:
**31.10.90 Patentblatt 90/44**

(84) Benannte Vertragsstaaten:
**CH DE FR GB IT LI SE**

(56) Entgegenhaltungen:
**EP-A- 0 071 276
EP-A- 0 196 122
FR-A- 2 406 301
US-A- 3 625 781
US-A- 3 860 947**

(73) Patentinhaber: **BBC Brown Boveri AG, Haselstrasse,
CH-5401 Baden(CH)**

(72) Erfinder: **Abbas, Christiaan, Dr., Im Eichtal 2,
CH-5400 Baden(CH)**

ACTORUM AG

## Beschreibung

Die vorliegende Erfindung betrifft ein Halbleiterbauelement gemäss dem Oberbegriff des Anspruchs 1 sowie ein Verfahren zur Herstellung eines solchen Bauelements. Ein Bauelement dieser Art ist z.B. aus der Druckschrift EP-A3 0 071 276 bekannt.

Die transienten Vorgänge beim Ausschalten von Halbleiterbauelementen, insbesondere Leistungshalbleiterbauelementen, erfordern im allgemeinen eine sogenannte Trägerstaubeschaltung (engl. "snubber network"), die dafür sorgt, dass die Bauelemente beim Ablauf von Schaltprozessen nicht zerstört werden. Üblicherweise umfasst eine solche Trägerstaubeschaltung die Serienschaltung eines Widerstands und eines Kondensators, welche parallel zum Halbleiterbauelement liegt.

Solche Trägerstaubeschaltungen sind, besonders bei zunehmender Leistung, teuer. Darüberhinaus verursachen sie Energieverluste, die bei höheren Leistungen und einer Vielzahl von Bauelementen erheblich ins Gewicht fallen können.

Andererseits kann jedoch bei den üblichen Halbleiterbauelementen auf diese Trägerstaubeschaltung nicht verzichtet werden, ohne das Bauelement der Gefahr einer Zerstörung auszusetzen.

Es ist daher Aufgabe der vorliegenden Erfindung, ein Halbleiterbauelement zu schaffen, bei welchem die transienten Vorgänge, welche das Bauelement beim Schalten hervorruft, nicht mehr selbstzerstörend sind und deshalb auf eine externe Trägerstaubeschaltung verzichtet werden kann.

Die Aufgabe wird bei einem Halbleiterbauelement der eingangs genannten Art durch die Merkmale aus dem Kennzeichen des Anspruchs 1 gelöst.

Der Kern der Erfindung besteht darin, durch geeignete Wahl eines axialen Profils der Träger-Lebensdauer das Verhalten des Halbleiterbauelements in gewünschter Weise so zu beeinflussen, daß eine Trägerstaubeschaltung nicht mehr notwendig ist.

Dazu wird ein inhomogenes Lebensdauerprofil vorgesehen, derart, daß

(a) das Profil der Lebensdauer eine grabenförmige Absenkung aufweist, wobei der durch die Absenkung festgelegte Teilbereich höchstens einen Teil der P-Schicht, den PN-Übergang und einen Teil der N-Schicht umfaßt; und

(b) die Lebensdauer außerhalb des Teilbereichs homogen ist.

Das erfindungsgemäße Herstellungsverfahren verwirklicht das Halbleiterbauelement mit dem inhomogenen Lebensdauerprofil durch Einbringung einer entsprechenden inhomogenen Verteilung von Haftstellen (engl. "traps"), welche die Lebensdauer gezielt herabsetzen, wobei eine erhöhte Haftstellenkonzentration zu einer erhöhten Herabsetzung der Lebensdauer führt.

Vorteilhafte weitere Ausgestaltungen der Erfindung ergeben sich aus den Unteransprüchen.

Die Erfindung soll nun nachfolgend unter Bezug auf die Zeichnung anhand von Ausführungsbeispielen näher erläutert werden. Es zeigen:

Fig. 1 den prinzipiellen Aufbau eines Halbleiterbauelements in Diodenform, welches den Berechnungen des transienten Verhaltens als Beispiel zugrundeliegt;

Fig. 2A die Darstellung eines Dotierungsprofils und eines stufenförmigen Haftstellenprofils für ein Bauelement nach Fig. 1, wie es z.B. aus der EP-A3 0 071 276 bekannt ist;

Fig. 2B eine Fig. 2A entsprechende Darstellung mit einem peak-förmigen Haftstellenprofil gemäß einem ersten bevorzugten Ausführungsbeispiel der Erfindung;

Fig. 2C eine Fig. 2B entsprechende Darstellung mit einem weiteren peakförmigen Haftstellenprofil gemäß einem zweiten bevorzugten Ausführungsbeispiel der Erfindung;

Fig. 3A, B Dotierungs- und Haftstellenprofile für eine Diode gemäß Fig. 1 mit homogener (Fig. 3A) und stufenförmiger (Fig. 3B) Haftstellenverteilung, wie sie in einer ersten vergleichenden Berechnung des transienten Verhaltens zugrundegelegt worden sind;

Fig. 4 die schematische Schaltungsanordnung für die Rechnersimulation des Abschaltverhaltens der Bauelemente gemäß Fig. 3A und B;

Fig. 5 den zeitlichen Verlauf der berechneten Ströme durch die Bauelemente und die Induktivität;

Fig. 6 den zeitlichen Verlauf der berechneten Spannungen am Bauelement;

Fig. 7 den zeitlichen Verlauf der an den Bauelementen abfallenden Verlustleistungen und Verlustenergien;

Fig. 8 den zeitlichen Verlauf der an Bauelement und Schaltungswiderstand abfallenden Verlustleistungen und Verlustenergien für ein Bauelement nach dem Stand der Technik;

Fig. 9 ein der weiteren Berechnung zugrundegelegtes Haftstellenprofil nach der Erfindung; und

Fig. 10 den zeitlichen Verlauf von Strom und Spannung für ein Bauelement mit Profilen gemäß Fig. 9.

Die Erfindung bezieht sich in ihrer allgemeinsten Form auf ein Halbleiterbauelement mit wenigstens einem zwischen einer Anode und einer Kathode angeordneten PN-Übergang. Dies kann beispielsweise ein Thyristor in der Gestalt eines Vierschichtbauelements mit mehreren PN-Übergängen sein. Dies kann jedoch auch gemäß einem bevorzugten Ausführungsbeispiel eine Diode mit nur einem PN-Übergang sein.

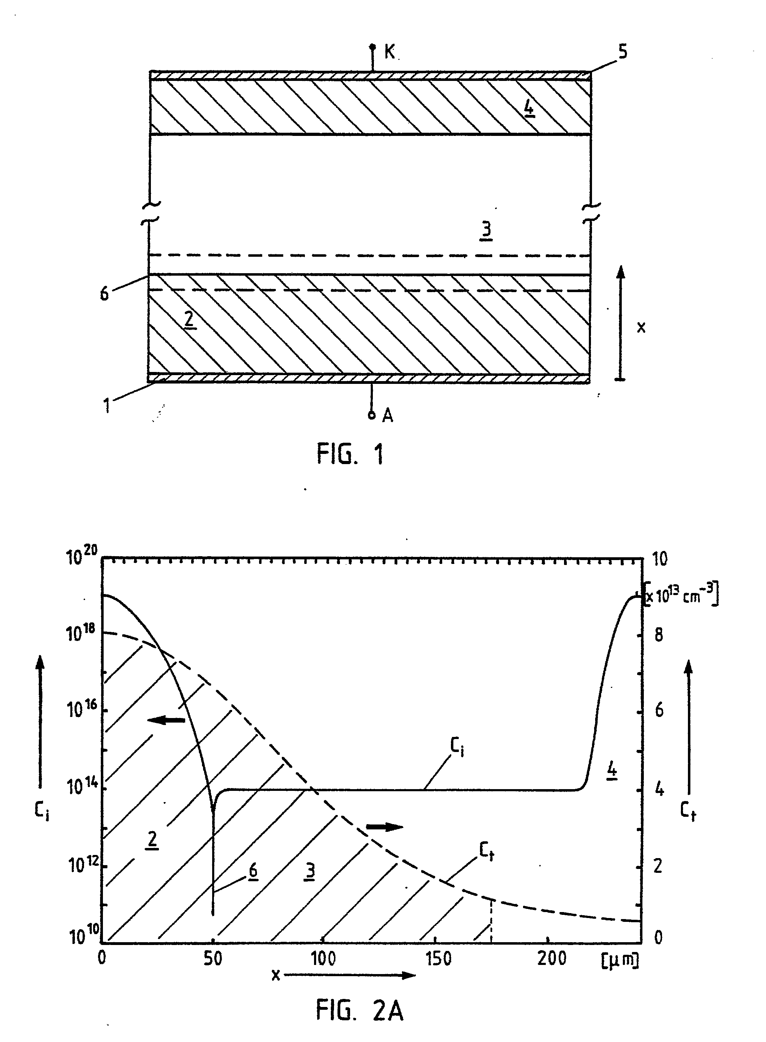

Eine solche Diode ist Gegenstand der nachfolgenden Ausführungen. Ihr schematischer Aufbau ist beispielhaft in der Fig. 1 dargestellt. Zwischen einer Anode A und einer Kathode K mit entsprechendem Anodenkontakt 1 und Kathodenkontakt 5 sind eine p-dotierte P-Schicht 2, eine n-dotierte N-Schicht 3 und eine hoch n-dotierte N+-Schicht 4, welche unmittelbar an die N-Schicht 3 anschließt, angeordnet.

Die P-Schicht 2 und die N-Schicht 3 bilden an ihrer gemeinsamen Grenze einen PN-Übergang 6, dessen Raumladungszone durch die gestrichelt eingezeichneten Linien angedeutet ist.

Den einzelnen Schichten bzw. Dotierungszonen der Fig. 1 entspricht ein bestimmter Verlauf der Dotierungskonzentration in axialer Richtung zwischen der Anode A und der Kathode K. Ein solcher Verlauf einer Dotierungskonzentration $C_i$, aufgetragen über der Entfernung X von der Anode A, ist in der Fig. 2A wiedergegeben. Dieser als durchgezogene Linie dargestellte Verlauf mit den dazugehörigen Skalen für die Entfernung X und die Dotierungskonzentration $C_i$ ist in allen weiteren Figuren, die sich auf den Dotierungsverlauf beziehen, gleich, und den nachfolgend erläuterten Berechnungen des transienten Verhaltens zugrundegelegt worden.

Die beispielhafte Dotierungskonzentration $C_i$ der Fig. 2A beginnt anodenseitig mit einer p-Dotierung im Randbereich von $10^{19}$ cm$^{-3}$, fällt über die Dicke der P-Schicht 2 zum PN-Übergang 6 hin steil ab und wechselt zu einer wesentlich geringeren n-Dotierung von $10^{14}$ cm$^{-3}$ im Bereich der N-Schicht 3, die sich vom PN-Übergang 6 bei X = 50 µm bis zu X = 215 µm erstreckt. In der angrenzenden N$^+$-Schicht 4 steigt die Dotierung dann auf einen kathodenseitigen Randwert von $10^{19}$ cm$^{-3}$ an. Die $C_i$-Skala ist auf der linken Seite des Diagramms angeordnet.

Neben der Dotierungskonzentration $C_i$ ist in der Fig. 2A außerdem eine Haftstellenkonzentration $C_t$ dargestellt, deren Skala, die im Unterschied zur logarithmischen $C_i$-Skala linear ist, auf der rechten Seite des Diagramms angeordnet ist.

Ein solcher Verlauf der Haftstellenkonzentration ist prinzipiell aus der eingangs erwähnten Druckschrift bekannt - siehe die dortige Fig. 1b - und wird dort verwendet, um eine Diode mit gleichzeitig kurzer Sperrverzögerungszeit und kleinem Leckstrom zu erzeugen.

Der Haftstellenkonzentration $C_t$ kommt nun folgende Bedeutung zu: Die Lebensdauer der Minoritätsträger in dem Halbleiterbauelement weist in axialer Richtung zwischen Anode A und Kathode K, d.h. in Abhängigkeit von der Entfernung X, ein inhomogenes Profil auf, bei dem die Lebensdauer innerhalb eines gewissen Teilbereichs des Bauelements gegenüber den übrigen Bereichen herabgesetzt ist. Der Teilbereich mit herabgesetzter Lebensdauer liegt dabei wenigstens teilweise in der N-Schicht 3.

Das inhomogene Profil der Lebensdauer wird durch eine entsprechende inhomogene Verteilung der Haftstellen im Bauelement eingestellt, wobei die Haftstellen als Rekombinationszentren wirken. Die Rekombinationsrate, welche die Lebensdauer bestimmt, hängt stark ab von der Dichte der Haftstellen im Bauelement: Für hohe Haftstellenkonzentration ergibt sich eine hohe Rekombinationsrate und damit eine kurze Lebensdauer, und umgekehrt.

Soll also ein Lebensdauerprofil erzeugt werden, das stufenförmig ist und im Anodenbereich niedrige Werte, im Kathodenbereich dagegen hohe Werte annimmt, ist eine ebenfalls stufenförmige Verteilung von Haftstellen notwendig, deren Haftstellenkonzentration $C_t$ wie in Fig. 2A dargestellt, im Anodenbereich hoch, im Kathodenbereich dagegen niedrig ist. Dem Teilbereich mit herabgesetzter Lebensdauer entspricht also in Fig. 2A der Teilbereich mit hoher Haftstellenkonzentration $C_t$ der in der Figur schraffiert eingetragen ist.

Der tatsächliche Verlauf der Haftstellenkonzentration $C_t$ hängt nun davon ab, welche Haftstellen auf welche Weise in das Bauelement eingebracht werden. So kann die Konzentrationsstufe, wie in Fig. 2A angedeutet, verschliffen sein. Entsprechend sind auch im Konzentrationsprofil außerhalb der Stufe endliche Steigungen denkbar. Wesentlich ist jedoch, daß der schraffierte Teilbereich zumindest teilweise in der N-Schicht 3 liegt, so daß auf dieser Seite des PN-Übergangs 6 die Lebensdauer der Minoritätsträger deutlich herabgesetzt ist.

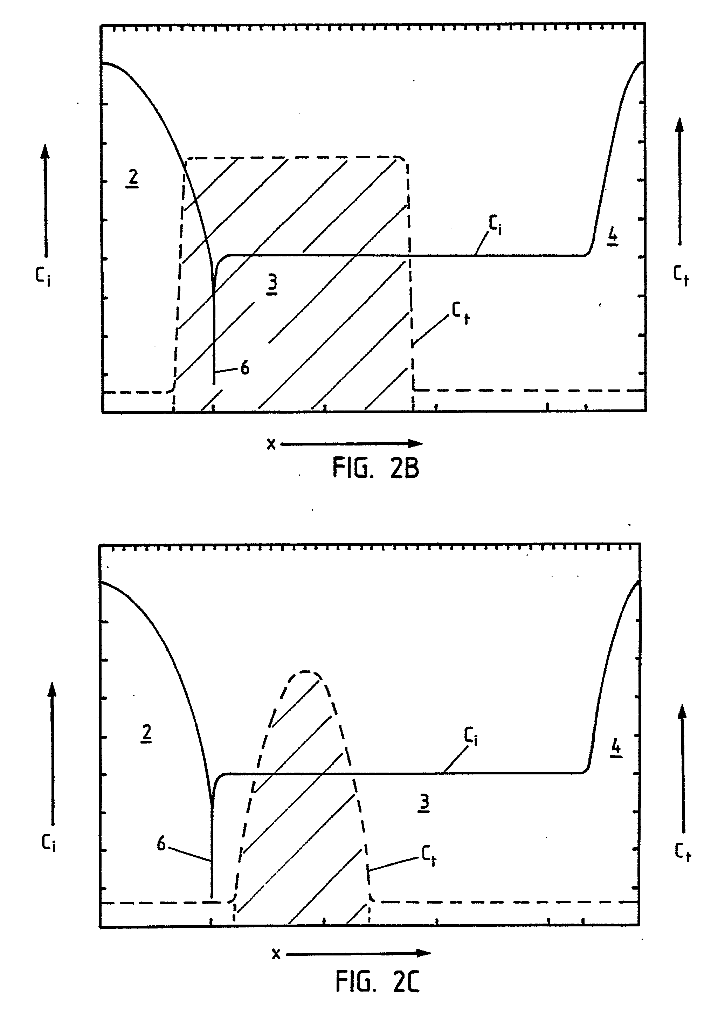

Im Unterschied zu dem stufenförmigen Profil der Fig. 2A sind in den Fig. 2B und 2C bevorzugte Ausführungsbeispiele von Verläufen der Haftstellenkonzentration $C_t$ nach der Erfindung in analoger Weise dargestellt, wobei wiederum die schraffierten Bereiche den Teilbereichen mit herabgesetzter Lebensdauer entsprechen. Die Skalen sind dieselben wie in Fig. 1A; ihre Beschriftung ist der Einfachheit halber weggelassen worden.

Im ersten Ausführungsbeispiel der Fig. 2B zeigt der Verlauf der Haftstellenkonzentration $C_t$ einen breiten Peak mit einem Plateau. Der Teilbereich mit herabgesetzter Lebensdauer, der dem schraffierten Bereich des Peaks in Fig. 2B entspricht, ist dann eine grabenförmige Absenkung im Profil der Lebensdauer. Er umfaßt einen Teil der P-Schicht 2, den PN-Übergang 6 und einen Teil der N-Schicht 3. Auch hier wird ein idealer, rechteckförmiger Verlauf des Konzentrationsprofils in der Praxis nicht erreicht, so daß die Flanken des Peaks andeutungsweise verschliffen eingezeichnet sind.

Der nichtideale Verlauf der Haftstellenkonzentration $C_t$ wird noch deutlicher im zweiten Ausführungsbeispiel der Fig. 2C, in dem der Peak auf einen kleineren Teilbereich beschränkt ist, der nun vollständig innerhalb der N-Schicht 3 liegt.

Die unterschiedlichen Verläufe der Haftstellenkonzentration $C_t$ in dem Bauelement gemäß Fig. 2A und in den Ausführungsbeispielen der Fig. 2B und 2C mit ihren entsprechenden Lebensdauerprofilen gehen vor allem zurück auf die unterschiedliche Art und Weise, in der die Haftstellen in das Bauelement eingebracht werden. Auf diese Unterschiede wird im Zusammenhang mit der späteren Erläuterung des erfindungsgemäßen Herstellungsverfahrens noch näher eingegangen.

Allen Konzentrationsverläufen ist jedoch gemeinsam, daß die Haftstellenkonzentration $C_t$ in einem Teilbereich erhöht ist, der sich über einen größeren, an den PN-Übergang 6 angrenzenden Teil der N-Schicht 3 erstreckt, weil gerade hier durch eine Absenkung der Lebensdauer die transienten Vorgänge im Bauelement besonders günstig beeinflußt werden können.

Für zwei ausgewählte Verläufe der Haftstellenkonzentration $C_t$ ist das Abschaltverhalten eines solchen Bauelements in Form einer Diode mittels einer Rechnersimulation untersucht und mit dem Verhalten eines herkömmlichen Bauelements mit Trägerstaubeschaltung verglichen worden.

Für die Rechnersimulation wurde ein speziell entwickeltes Rechnerprogramm COMPASS (Computer Program for the Analysis of Semiconductors) verwendet, welches in der Dissertation von C. Abbas "Transient One-Dimensional Numerical Analysis of Bipolar Power Semiconductor Devices", ETH Zürich, No. 7614, 1984, beschrieben und erläutert ist. Wie aus der Druckschrift zu entnehmen ist, führt die Simulation mit dem Programm COMPASS zu realistischen Ergebnissen, die mit den gemessenen Werten in sehr guter Übereinstimmung stehen. Aus diesem Grunde können die Vorteile des erfindungsgemäßen Halbleiterbauelements gegenüber einem herkömmlichen mit Trägerstaubeschaltung direkt an den Simulationsergebnissen deutlich gemacht werden.

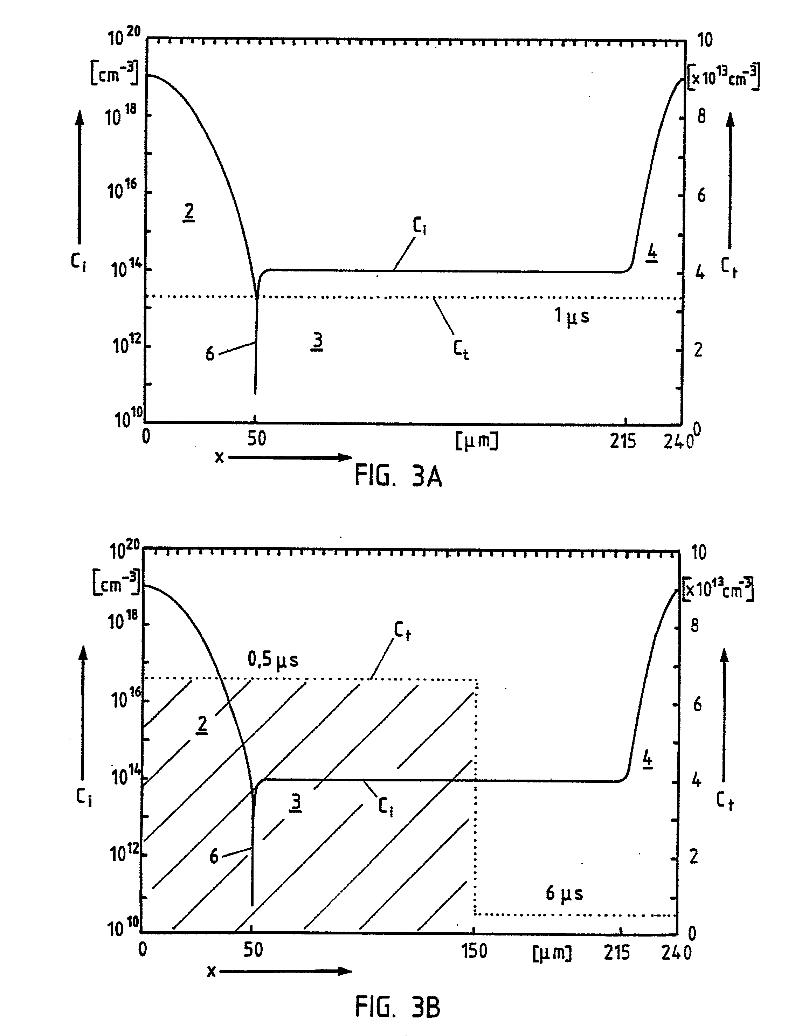

Der durchgeführte Simulationsvergleich geht aus von einer Diode mit einer Dotierungskonzentration $C_i$ gemäß Fig. 3A für das Bauelement ohne inhomogene Haftstellenkonzentration. Dem wird gegenübergestellt eine Diode mit gleicher Dotierungskonzentration $C_i$, aber inhomogener, stufenförmiger Haftstellenkonzentration $C_t$ gemäß Fig 3B.

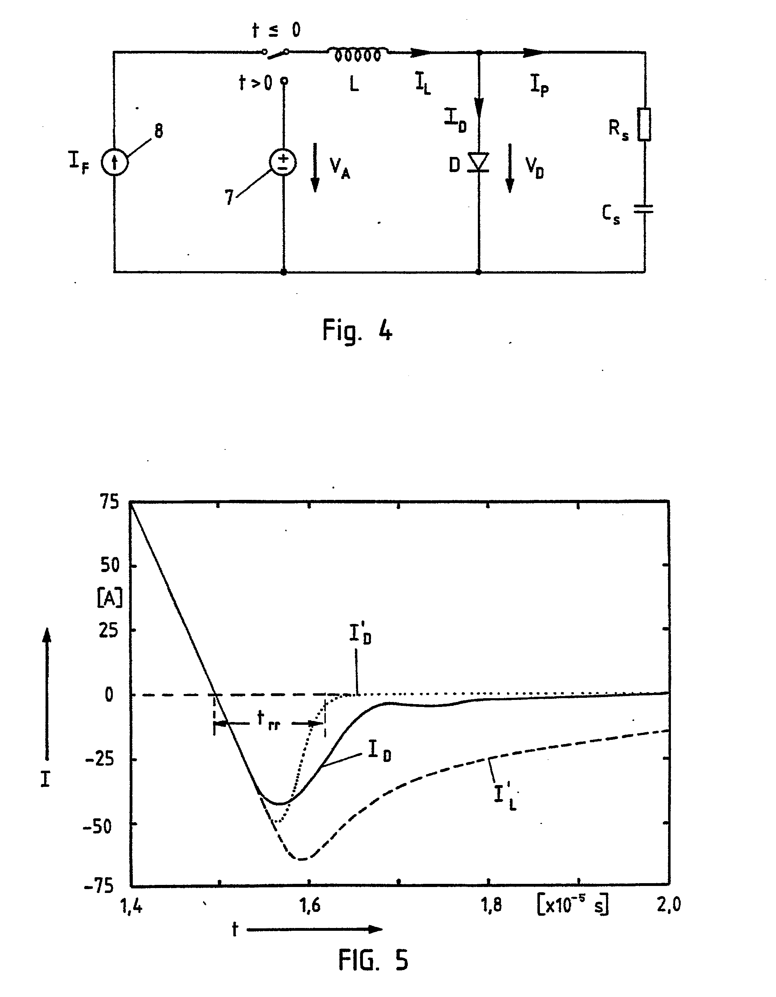

Für die Simulation des Abschaltverhaltens werden bei dem Programm COMPASS die Bauelemente in eine Schaltung gemäß Fig. 4 eingesetzt gedacht. Diese Schaltung enthält neben der zu untersuchenden Diode D die aus einem Beschaltungswiderstand $R_S$ und einem Beschaltungskondensator $C_S$ bestehende Trägerstaubeschaltung.

Die Diode D bildet zusammen mit der Induktivität L und, wahlweise über einen Umschalter anwählbar, entweder mit einer Stromquelle 8 für den Durchlaßstrom $I_F$, oder mit einer Spannungsquelle 7 für die angelegte Spannung $V_A$ einen Stromkreis.

Für die Zeit $t \leq 0$ ist die Diode D mit der Stromquelle 8 verbunden, für $t > 0$ wird auf die Spannungsquelle 7 umgeschaltet. Durch die Induktivität L fließt ein Gesamtstrom $I_L$, der sich aufteilt in einen Strom $I_p$ durch die Trägerstaubeschaltung und einen Diodenstrom $I_D$. An der Diode D fällt eine Diodenspannung $V_D$ ab.

Naturgemäß wird die aus $R_S$ und $C_S$ bestehende Trägerstaubeschaltung nur für die Diode herkömmlicher Art in der Simulation berücksichtigt. Für die Diode mit inhomogener Haftstellenkonzentration $C_t$ bzw. inhomogenem Lebensdauerprofil wird die Simulation selbstverständlich ohne diese Beschaltung durchgeführt.

Als ein Ergebnis der Simulation sind in Fig. 5 die zeitlichen Verläufe des Diodenstroms $I_D$ für eine Diode mit inhomogener Haftstellenverteilung (hier gilt wegen der fehlenden Trägerstaubeschaltung $I_L = I_D$) sowie des Gesamtstroms $I_{L'}$ und des Diodenstroms $I_{D'}$ für eine herkömmliche Diode aufgetragen.

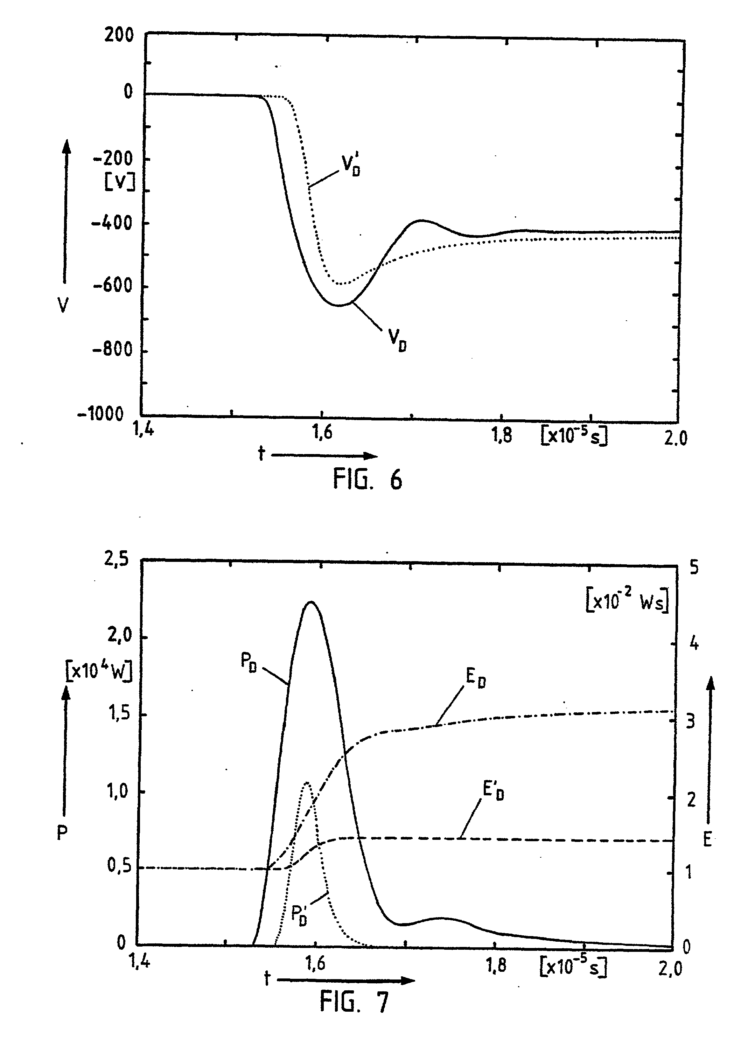

Vorausgesetzt sind dabei Lebensdauern von 0,5 μs im schraffierten Bereich der Fig. 3B und 6 μs im übrigen Bereich, sowie 1 μs über den gesamten Bereich der Fig. 3A.

Die Stufe in der Haftstellenkonzentration $C_t$ der Fig. 3B liegt in einer Tiefe von X = 150 μm. Der Beschaltungswiderstand $R_S$ hat einen Wert von $R_S = 10$

[Ohm], der Beschaltungskondensator $C_S$ einen Wert von $C_S = 0,47$ [μF]. Der Wert der Induktivität L beträgt L = 5 [μH], die angelegte Spannung $V_A$ hat einen Wert von $V_A = -400$ [V].

Alle drei Ströme $I_D$, $I_{D'}$ und $I_{L'}$ durchlaufen, von positiven Werten im Durchlaßzustand kommend, die Nulllinie, erreichen einen negativen Maximalwert, und fallen dann mehr oder weniger langsam auf Null ab. Ein Maß für die Schnelligkeit, mit der dieses negative Strommaximum durchlaufen wird, ist die sogenannte Sperrverzugszeit $t_{rr}$ (engl. "reverse recovery time"). Sie ist meist definiert als Zeitspanne vom Nulldurchgang des Stromes bis zum Abfall auf 10% des negativen Maximalwertes.

Aus der Fig. 5 ist ersichtlich, daß zwar der Diodenstrom $I_{D'}$ durch eine Diode D der herkömmlichen Art mit der Sperrverzugszeit von $t_{rr} = 1,1$ μs schneller abklingt, als der Diodenstrom $I_D$ durch eine inhomogen dotierte Diode D mit einer Sperrverzugszeit von $t_{rr} = 1,7$ μs.

Betrachtet man jedoch das Abklingen des Gesamtstroms $I_L$, sprechen die Ereignisse zugunsten der inhomogen dotierten Diode. Da nämlich wegen der fehlenden Trägerstaubeschaltung $I_L = I_D$ gilt, ist die Sperrverzugszeit $t_{rr}$ der inhomogen dotierten Diode für beide Ströme gleich.

Bei der herkömmlichen Diode dagegen addiert sich der Strom $I_p$ durch die Trägerstaubeschaltung zu dem Diodenstrom $I_{D'}$ und ergibt einen Gesamtstrom $I_{L'}$, der mit einer Sperrverzugszeit von $t_{rr} = 6,1$ μs deutlich langsamer abklingt, als im Falle der inhomogen dotierten Diode.

Insgesamt gesehen ist also ein Halbleiterbauelement mit einem inhomogenen Verlauf der Haftstellenkonzentration, wie er aus der eingangs genannten Druckschrift bekannt ist, einem herkömmlichen Bauelement hinsichtlich der Abschaltschnelligkeit eindeutig überlegen. Darüberhinaus ist auch das Rückstrommaximum des Gesamtstroms bei dieser Diode mit 43,4 A wesentlich kleiner als bei der herkömmlichen Diode mit 65 A.

Der Verlauf der entsprechenden Diodenspannung $V_D$ und $V_{D'}$ während des Abschaltvorganges ist in Fig. 6 dargestellt. Hier liegt das rückwärtige Spannungsmaximum für die inhomogen dotierte Diode (Diodenspannung $V_D$) mit 649 V über dem vergleichbaren Wert von 582 V für die herkömmliche Diode (Diodenspannung $V_{D'}$). Gleichwohl sind beide Werte weit unterhalb der Durchbruchspannung angesiedelt, die für die simulierten Bauelemente 1500 V beträgt.

Abgesehen von der Gesamtschaltzeit sind auch die Gesamtverlustenergie und die maximale Verlustleistung wichtige Kriterien für die Beurteilung der Halbleiterbauelemente. Fig. 7 vergleicht diese Größen für die inhomogen dotierte (ungestrichene Größen) und eine herkömmliche (gestrichene Größen) Diode. Mit $P_D$ und $P_{D'}$ sind dabei die Diodenverlustleistungen bezeichnet, mit $E_D$ und $E_{D'}$ die zugehörigen Verlustenergien.

Bei dieser nur auf das Bauelement beschränkten Einzelbetrachtung der Leistungen und Energien gemäß Fig. 7 ist die inhomogen dotierte Diode scheinbar mit Nachteilen gegenüber der herkömmlichen Diode behaftet (höhere maximale Verlustleistung $P_D > P_{D'}$).

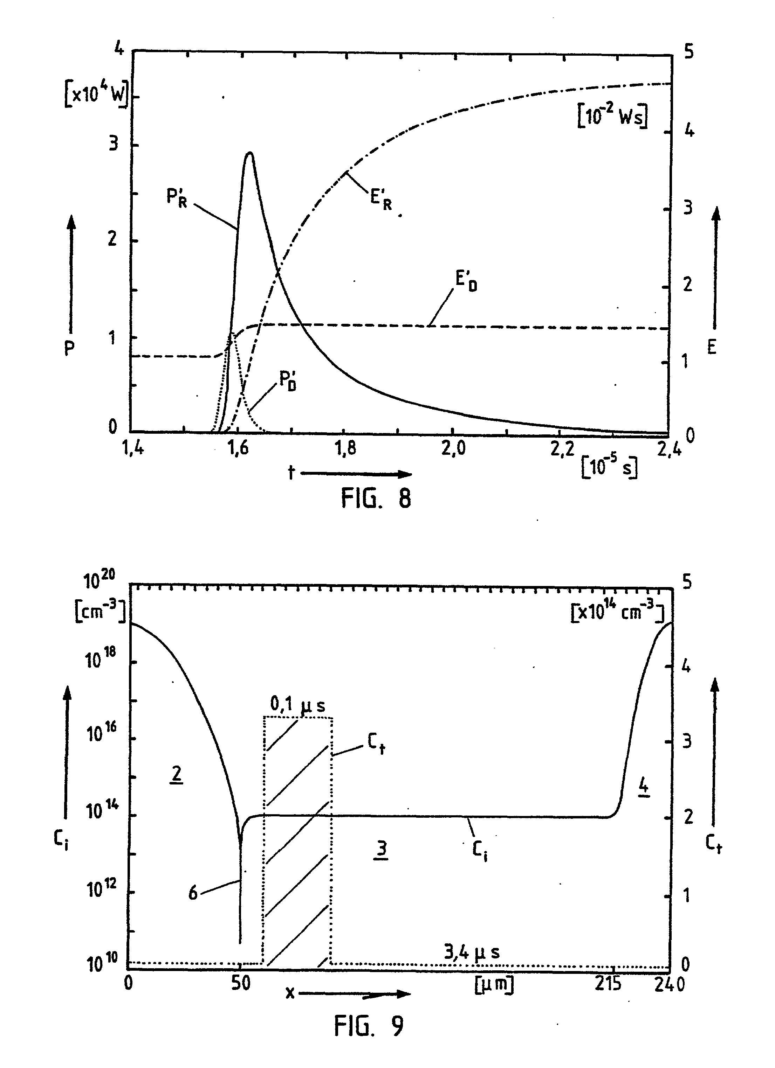

Ein gerechter Vergleich beider Bauelemente muß jedoch zusätzlich die Verlustleistung und Verlustenergie in der Trägerstaubeschaltung des herkömmlichen Bauelements berücksichtigen. In der Fig. 8 sind daher für eine herkömmliche Diode neben der Diodenverlustleistung $P_{D'}$ und Diodenverlustenergie $E_{D'}$ aus Fig. 7 auch die Widerstandsverlustleistung $P_{R'}$ und die Widerstandsverlustenergie $E_{R'}$ am Beschaltungswiderstand $R_s$ eingetragen. Addiert man diese Leistungen und Energien und stellt sie den Werten für $P_D$ und $E_D$ einer inhomogen dotierten Diode aus Fig. 7 gegenüber, ergibt sich, daß die Gesamtverlustenergie $(E_{D'} + E_{R'})$ für eine herkömmliche Diode mit 61 mJ doppelt so groß ist, wie die Diodenverlustenergie $E_D = 31$ mJ für eine inhomogen dotierte Diode gemäß Fig. 7.

Aus diesem Vergleich lassen sich insgesamt die folgenden Vorteile für ein Halbleiterbauelement mit inhomogener Verteilung der Trägerlebensdauer gegenüber einem herkömmlichen Bauelement zusammenstellen:

– der Aufwand der äußeren Trägerstaubeschaltung entfällt, was neben einer Kosten- auch eine Platz- und Gewichtsersparnis bedeutet;
– das Bauelement zeigt insgesamt (unter Berücksichtigung der Trägerstaubeschaltung im herkömmlichen Fall) ein schnelleres Schaltverhalten; und
– das Bauelement hat insgesamt (unter Berücksichtigung der Trägerstaubeschaltung im herkömmlichen Fall) eine geringere Gesamtverlustleistung.

Mit dem Simulationsprogramm COMPASS ist nun ein bevorzugtes Ausführungsbeispiel eines erfindungsgemäßen Bauelements in Form einer Diode mit einer peak-förmigen Verteilung der Haftstellen durchgerechnet worden. Die Dotierungskonzentration $C_i$ und die Haftstellenkonzentration $C_t$ für diese beispielhafte Diode sind in Fig. 9 dargestellt.

Die Haftstellenkonzentration $C_t$ weist dabei einen rechteckförmigen Peak im Bereich zwischen X = 60 μm und X = 90 μm auf. In diesem Bereich beträgt die Lebensdauer 0,1 μs. In den übrigen Bereichen liegt die Lebensdauer dagegen bei 3,4 μs.

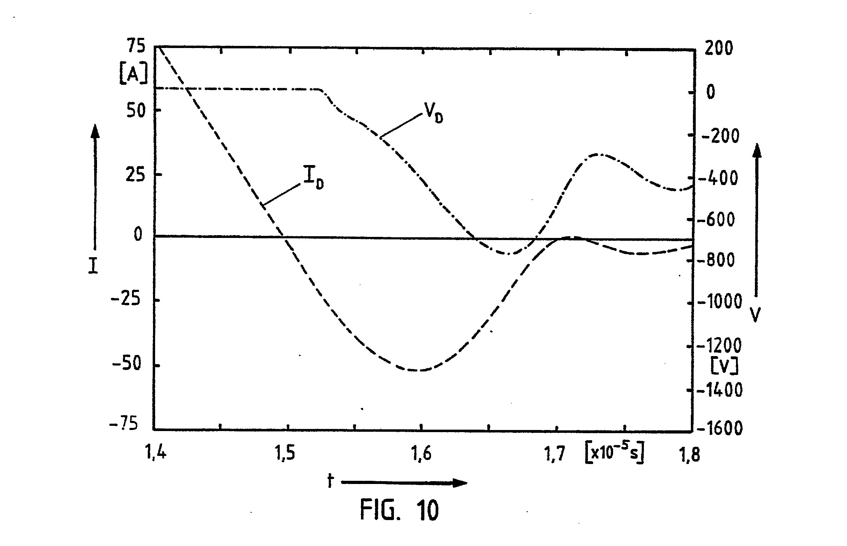

Das unter diesen Voraussetzungen simulierte Abschalteverhalten führt zu zeitlichen Verläufen des Diodenstroms $I_D$ und der Diodenspannung $V_D$, die in Fig. 10 wiedergegeben sind. Hier erreicht man eine Sperrverzugszeit $t_{rr}$ von weniger als 2 μs gegenüber den mehr als 6 μs bei einer herkömmlichen Diode. Die Rückstromspitze des Gesamtstroms ist wiederum kleiner als bei einer vergleichbaren herkömmlichen Diode, so daß bei einer Diode mit dem neuen Profil dieselben Vorteile gegenüber einem herkömmlichen Bauelement ins Gewicht fallen, wie sie oben aufgezählt worden sind.

Zur Erzeugung einer Haftstellenverteilung mit einem Peak gemäß Fig. 2B, 2C oder 9, d.h. zur Erzeugung eines inhomogenen Lebensdauerprofils mit grabenförmiger Absenkung wird das Bauelement erfindungsgemäß mit Protonen oder Helium-Atomen bestrahlt, die eine bestimmte Energie aufweisen und eine entsprechende Eindringtiefe besitzen. Diese Teilchen bilden in einer der Eindringtiefe vergleichbaren Entfernung zur Oberfläche Haftstellen in einer peak-förmigen Verteilung. Diese peak-förmige Verteilung, die bei einer definierten Teilchenenergie vergleichsweise schmal ist, kann zu einem Peak mit breiterem Plateau gemäß Fig. 2B erweitert werden, indem mehrmals mit variierender Teilchenenergie bestrahlt wird.

Die Bestrahlung mit Protonen oder Helium-Atomen schafft für sich genommen noch keine definierte Lebensdauer in denjenigen Bereichen des Bauelements, in denen die Lebensdauer nicht abgesenkt ist. Um diese homogene Grund-Lebensdauer einzustellen, wird das beschriebene inhomogene Verfahren mit entsprechenden homogenen Verfahren vorteilhafterweise kombiniert.

Als homogene Verfahren zur Einstellung eines homogenen Lebensdauerprofils bieten sich neben der an sich bekannten Haftstellendiffusion mit Gold- oder Platin-Atomen auch eine homogene Bestrahlung mit Elektronen an, wie sie z.B. aus der Druckschrift FR-A 2 406 301 bekannt ist.

Insgesamt werden mit den erfindungsgemäßen Halbleiterbauelementen und dem dazugehörigen Herstellungsverfahren Mittel bereitgestellt, um in der Leistungselektronik weniger aufwendige und verlustärmere Schaltungen bei gleichzeitig verbesserten Schaltzeiten zu realisieren.

**Patentansprüche**

1. Halbleiterbauelement mit wenigstens einem, zwischen einer Anode (A) und einer Kathode (K) angeordneten PN-Übergang (6), welcher durch eine anodenseitige P-Schicht (2) und eine an die P-Schicht (2) anschließende N-Schicht (3) gebildet wird, wobei die Lebensdauer der Minoritätsträger in axialer Richtung zwischen Anode (A) und Kathode (K) ein inhomogenes Profil aufweist und die Lebensdauer innerhalb dieses Profils in einem Teilbereich des Bauelements gegenüber den übrigen Bereichen herabgesetzt ist, dadurch gekennzeichnet, daß
(a) das Profil der Lebensdauer eine grabenförmige Absenkung aufweist, wobei der durch die Absenkung festgelegte Teilbereich höchstens einen Teil der P-Schicht (2), den PN-Übergang und einen Teil der N-Schicht (3) umfaßt; und
(b) die Lebensdauer außerhalb des Teilbereichs homogen ist.

2. Halbleiterbauelement nach Anspruch 1, dadurch gekennzeichnet, daß der durch die Absenkung festgelegte Teilbereich vollständig in der N-Schicht (3) liegt.

3. Halbleiterbauelement nach einem der Ansprüche 1 und 2, dadurch gekennzeichnet, daß die Lebensdauer im Teilbereich gegenüber der Lebensdauer in den übrigen Bereichen um wenigstens einen Faktor 2, vorzugsweise um einen Faktor von etwa 10, herabgesetzt ist.

4. Halbleiterbauelement nach einem der Ansprüche 1 bis 3, dadurch gekennzeichnet, daß
(a) das Halbleiterbauelement eine Diode ist;

(b) die P-Schicht (2) zur Anode (A) hin p+-dotiert ist; und

(c) die N-Schicht (3) zur Kathode (K) hin in eine n+-dotierte N+-Schicht (4) übergeht.

5. Verfahren zur Herstellung eines Halbleiterbauelements nach Anspruch 1, bei welchem zur Erzeugung des inhomogenen Profils der Lebendauer eine in axialer Richtung inhomogene Verteilung von Haftstellen in das Bauelement eingebracht wird, dadurch gekennzeichnet, daß

(a) zur Erzeugung des Profils der Lebensdauer mit grabenförmiger Absenkung das Bauelement mit Protonen oder Helium-Atomen bestrahlt wird, deren Energie bzw. Eindringtiefe mit der Lage der grabenförmigen Absenkung korreliert ist; und

(b) neben der durch die Bestrahlung erzeugten inhomogenen Haftstellenverteilung zusätzlich eine homogene Haftstellenverteilung durch homogene Diffusion, vorzugsweise von Gold- oder Platin-Atomen, oder durch homogene Elektronenbestrahlung, erzeugt wird.

## Claims

1. Semiconductor component having at least one p-n junction (6) which is arranged between an anode (A) and a cathode (K) and which is formed by an anode-side p-layer (2) and n-layer (3) adjacent to the p-layer (2), in which arrangement the life of the minority carriers in the axial direction between anode (A) and cathode (K) exhibits an inhomogeneous profile and the life within this profile is reduced in a part region of the component compared with the remaining regions, characterized in that

(a) the profile of the life exhibits a trough-shaped depression, the part-region defined by the depression comprising at the most a part of the p-layer (2), the p-n junction and a part of the n-layer (3); and

(b) the life outside the part region is homogeneous.

2. Semiconductor component according to Claim 1, characterized in that the part region defined by the depression is completely located within the n-layer (3).

3. Semiconductor component according to one of Claims 1 and 2, characterized in that the life in the part region is reduced by at least a factor of 2, preferably a factor of about 10, compared with the life in the remaining regions.

4. Semiconductor component according to one of Claims 1 to 3, characterized in that

(a) the semiconductor component is a diode;

(b) the p-layer (2) is p+-doped towards the anode (A); and

(c) the n-layer (3) changes into an n+-doped n+-layer (4) towards the cathode (K).

5. Method for producing a semiconductor component according to Claim 1, in which, for the purpose of generating the inhomogeneous profile of the life, a distribution of traps which is inhomogeneous in the axial direction is incorporated into the component, characterized in that

(a) for generating the profile of the life having a trough-shaped depression, the component is irradiated with protons or helium atoms the energy or depth of penetration of which is correlated with the position of trough-shaped depressions; and

(b) in addition to the inhomogeneous trap distribution generated by the irradiation, a homogeneous trap distribution is additionally generated by homogeneous diffusion, preferably of gold or platinum atoms, or by homogeneous electron irradiation.

## Revendications

1. Composant semi-conducteur comprenant au moins une transition PN (6) agencée entre une anode (A) et une cathode (K), qui est formé par une couche P (2) du côté de l'anode et une couche N (3) contiguë à la couche P (2), la durée de vie des porteurs minoritaires dans la direction axiale entre l'anode (A) et la cathode (K) présentant un profil inhomogène et la durée de vie à l'intérieur de ce profil étant abrégée dans un domaine partiel du composant par rapport aux autres domaines, caractérisé en ce que:

(a) le profil de la durée de vie présente une dépression en forme de fossé, de façon que le domaine partiel fixé par la dépression comprenne au maximum une partie de la couche P (2), la transition PN et une partie de la couche N (3), et

(b) la durée de vie est homogène à l'extérieur du domaine partiel.

2. Composant semi-conducteur suivant la revendication 1, caractérisé en ce que le domaine partiel défini par la dépression est situé entièrement dans la couche N (3).

3. Composant semi-conducteur suivant la revendication 1 ou 2, caractérisé en ce que la durée de vie dans le domaine partiel est diminuée par rapport à la durée de vie dans les autres domaines, au moins d'un facteur 2 et de préférence d'un facteur d'environ 10.

4. Composant semi-conducteur suivant l'une quelconque des revendications 1 à 3, caractérisé en ce que:

(a) le composant semi-conducteur est une diode;

(b) la couche P (2) est dopée p+ en direction de l'anode (A), et

(c) la couche N (3) est suivie d'une couche N+ (4) dopée n+ en direction de la cathode (K).

5. Procédé de fabrication d'un composant semi-conducteur suivant la revendication 1, dans lequel une répartition inhomogène des pièges est établie dans le composant pour obtenir un profil inhomogène de la durée de vie en direction axiale, caractérisé en ce que:

(a) pour l'établissement du profil de la durée de vie avec une dépression en forme de fossé, le composant est irradié avec des protons ou des atomes d'hélium, dont l'énergie ou la profondeur de pénétration est en corrélation avec la position de la dépression en forme de fossé, et

(b) en plus de la répartition inhomogène des pièges obtenue par irradiation, une répartition homogène des pièges est obtenue par diffusion homogène, de préférence d'atomes d'or ou de platine, ou par une irradiation homogène au moyen d'électrons.

FIG. 1

FIG. 2A

FIG. 2B

FIG. 2C

EP 0 235 550 B1

FIG. 3A

FIG. 3B

Fig. 4

FIG. 5

FIG. 6

FIG. 7

FIG. 8

FIG. 9

FIG. 10